# NEUE EUROPÄISCHE PATENTSCHRIFT

(11) **EP 2 317 078 B2**
(45) Veröffentlichungstag und Bekanntmachung des Hinweises auf die Entscheidung über den Einspruch: **01.09.2021**
(45) Hinweis auf die Patenterteilung: 19.10.2016
(21) Anmeldenummer: 10188811.3
(22) Anmeldetag: 26.10.2010
(51) Int. Cl.: C23C 26/00, B23K 101/34, B23K 101/00, F01D 5/20, F01D 5/28, F01D 11/12, F01D 5/00, F01D 11/14, C30B 29/52, C30B 13/24, C23C 28/00, B23K 35/32, B23K 35/30, B23K 26/34, B23K 26/322

(54) **Abrasive einkristalline Turbinenschaufel**
Abrasive single-crystal turbine blade
Aube de turbine abrasive monocristalline

(30) Priorität: 02.11.2009 DE 102009051664
(43) Veröffentlichungstag der Anmeldung: 04.05.2011
(73) Patentinhaber: Ansaldo Energia IP UK Limited, London W1G 9DQ (GB)
(72) Erfinder: Hoebel, Matthias, 5210 Windisch (CH); Schnell, Alexander, 5400 Baden (CH); Pellaton, Yves, 5443 Niederrohrdorf (CH)
(74) Vertreter: Bernotti, Andrea

(56) Entgegenhaltungen:
- EP-A1- 1 391 537
- EP-A1- 1 424 158
- EP-A2- 1 275 743
- WO-A1-2009/083000
- CN-A- 1 776 025
- US-A- 5 997 248
- US-A1- 2004 156 724

## Beschreibung

Die Erfindung bezieht sich auf das Gebiet der Gasturbinen- und Werkstofftechnik. Sie betrifft eine abrasive einkristalline Turbinenschaufel mit hoher Beständigkeit gegenüber Oxidation und Reibverschleiss sowie ein Herstellungsverfahren für eine derartige abrasive einkristalline Turbinenschaufel.

### Stand der Technik

Die Verringerung von Leckageverlusten in Turbinen ist seit mehreren Jahrzehnten Gegenstand intensiver Entwicklungsarbeiten. Während des Betriebes einer Gasturbine ist eine Relativbewegung zwischen Rotor und Gehäuse unvermeidbar. Der daraus resultierende Verschleiss des Gehäuses bzw. Verschleiss der Schaufeln führt dazu, dass die Dichtwirkung nicht mehr gegeben ist. Als Lösung für dieses Problem wird eine Kombination von dicken abschleifbaren Beschichtungen am Hitzeschild mit abrasiven Schutzschichten an den Schaufelspitzen vorgesehen.

Bereits seit den 70er Jahren des letzten Jahrhunderts kennt man Methoden, zusätzliche Beschichtungen auf Schaufelspitzen aufzubringen oder durch eine geeignete Modifikation der Schaufelspitze die Verschleissbeständigkeit zu erhöhen. Es sind ebenfalls verschiedene Methoden vorgeschlagen worden, um solche Schutzschichten durch eine Kombination von Abrasivteilchen (Karbiden, Nitriden, etc.) mit oxidationsresistenten Materialien gleichzeitig beständig gegenüber Reibkontakten und durch das Heissgas verursachter Oxidation zu machen. Viele der vorgeschlagenen Methoden sind jedoch in der Herstellung kostenintensiv und komplex, was einen kommerziellen Einsatz erschwert. Dies gilt vor allem auch für die Anwendung dieser Methoden auf einkristalline Turbinenschaufeln. Hier ergeben sich durch die spezielle einkristalline Mikrostruktur des Grundmaterials zusätzliche Anforderungen an den Fertigungsprozess. Insbesondere darf der Grundkörper der Turbinenschaufel durch die Fertigung der abrasiven Schaufelspitze möglichst wenig beeinflusst werden. Dies schliesst das Vermeiden von Defekten am Interface zum Grundkörper der Schaufel ein.

Eine der populären Strategien besteht deshalb darin, auf den Verschleissschutz der Schaufelspitze ganz zu verzichten und das Hitzeschild mit speziellen, porösen keramischen Einreibschichten zu versehen. Diese können auf Grund ihrer hohen Porosität in gewissem Umfang auch von ungeschützten Schaufelspitzen eingerieben werden. Mit dieser Methode sind jedoch erhebliche technische Risiken verbunden, da die porösen keramischen Einreibschichten nicht die gleiche Erosionsbeständigkeit wie dichte Schichten gewährleisten. Ein weiteres Risiko besteht in betriebsbedingten Veränderungen der porösen keramischen Einreibschichten (Verdichtung durch Sintern), die sich negativ auf die tribologischen Eigenschaften auswirken können. Aus diesem Grund ist bei der Verwendung keramischer Schutzschichten auf Hitzeschildern eine Kombination mit verschleissfesten (abrasiven) Schaufelspitzen ratsam.

Abrasiv beschichtete Turbinenschaufeln sind bereits seit den 60-er Jahren des vergangenen Jahrhunderts bekannt. In den letzten Jahrzehnten sind mehrere Verfahren zur Erzeugung abrasiver Schaufelspitzen entwickelt und durch zahlreiche Patente geschützt worden, siehe z.B: US 6194086 B1. Der Einsatz des Laserauftragsschweissens (Englisch: Laser Metal Forming, abgekürzt LMF) zum Aufbau abrasiver Schaufelspitzen ist zwar seit Beginn der 90-er Jahre bekannt (siehe beispielsweise DE 10 2004 059 904 A1), diese Methode wird im industriellen Massstab jedoch noch selten eingesetzt.

In EP 1295969 A1 und EP 1295970 A1 werden MCrAlY-Materialien offenbart, welche als relativ grossflächige Oxidationsschutzschichten mit bestmöglicher Anpassung an einen einkristallinen Grundwerkstoff eingesetzt werden.

Ebenso ist auch das (epitaktische) E-LMF-Verfahren zum kontrollierten Umschmelzen von oder Auftragsschweissen auf einkristalline Komponenten bekannt (EP 1476272 B1).

Bisher nicht bekannt ist jedoch die Erzeugung von abrasiven Schutzschichten mit einer epitaktisch erstarrter Zwischenschicht auf einkristallinem Grundwerkstoff.

Im Dokument EP 1424 158 A1 wird ein Verfahren zur Herstellung, Modifizierung oder Reparatur von Einkristallartikeln oder gerichtet erstarrten Artikeln, beispielsweise Turbinenschaufeln beschrieben, bei welchem zwei vorgefertigte einkristalline bzw. gerichtet erstarrte Teile unter Verwendung eines Lötmaterial isothermisch gelötet werden. Anschliessend wird eine epitaktische oder nicht-epitaktische Schicht mittels Laserauftragsschweissen auf die Oberfläche des Artikels und der Lötverbindung aufgebracht, um die Qualität der Verbindung zu verbessern. Es wird auch beschrieben, dass es mittels epitaxialen Laserauftragsschweissen möglich ist, zusätzliches Einkristallmaterial abzuscheiden, um die Reparatur einer verschlissenen Komponente durch Herstellung der ursprünglichen Form zu beenden oder um einen neu designten Oberflächenbereich zu einer Rapid-Prototyp-Komponente hinzuzufügen,

### Darstellung der Erfindung

Ziel der Erfindung ist es, die Nachteile des bekannten Standes der Technik zu vermeiden. Der Erfindung liegt die Aufgabe zugrunde, ein Verfahren zur Herstellung einer abrasiven einkristallinen Turbinenschaufel und eine derartige hergestellte Turbinenschaufel zu entwickeln, welche sich durch hohe Oxidations- und Reibverschleissbeständigkeit auszeichnet, wobei den Prozessanforderungen, die sich aus der einkristallinen Natur des Schaufelwerkstoffs ergeben, besondere Beachtung geschenkt wird. Ebenso wird die Einsatzmöglichkeit zum Rekonditionieren oder Retrofit einkristalliner Komponenten abgedeckt.

Erfindungsgemäss wird diese Aufgabe dadurch gelöst, dass bei einem Verfahren zur Herstellung einer Turbinenschaufel für den Rotor einer Turbine, mit einem eine Schaufelspitze_ aufweisenden sich in radialer Richtung (auf den Rotor bezogen) erstreckenden einkristallinen Grundkörper und einer radial aussen gelegenene Schaufelspitze an der Schaufelspitze mindestens eine oxidationsbeständige MCrAlY-Zwischenschicht mittels Laserauftragsschweissen epitaktisch auf die Oberfläche des Grundkörper aufgebracht wird und auf dieser epitaktischen Zwischenschicht mittels Laserauftragsschweissen zumindest bereichsweise eine mindestens einlagige verschleiss- und oxidationsbeständige Schicht aus oxidationsbeständigem Bindermaterial und darin eingebetteten Abrasivteilchen aufgebracht wird, wobei das für die oxidationsbeständige Zwischenschicht verwendete Material auch als Bindermaterial in der verschleiss- und oxidationsbeständigen Schicht verwendet wird, wobei die MCAlY-Legierung vom γ/β oder γ/γ' Typ besteht

Vorteilhafterweise wird während des Aufbaus der Zwischenschicht und der verschleiss- und oxidationsbeständigen Schicht mit dem Laserauftragsschweissverfahren online die Temperatur oder Temperaturverteilung im Schmelzbad erfasst, so dass diese Information mit Hilfe eines Regelsystems verwendet werden kann, um die Laserleistung während des Laserauftragsschweissverfahrens und/oder die Relativbewegung zwischen Laserstrahl und Turbinenschaufel so zu kontrollieren, dass der Quotient Gⁿ/Vₛ oberhalb des materialabhängigen Grenzwertes liegt, der zur gerichteten, einkristallinen Erstarrung erforderlich ist, wobei mit G der lokale Temperaturgradient, Vₛ die Geschwindigkeit der Erstarrungsfront und n ein weiterer Materialparameter bezeichnet sind.

Die Vorteile der Erfindung bestehen darin, dass einkristalline Turbinenschaufeln mit optimierter Lebensdauer der abrasiven Schaufelspitze bei hohen Einsatztemperaturen realisiert werden. Im Zusammenspiel mit einer geeigneten Anstreifschicht auf der Statorseite, werden die Leckageverluste über den Heissgasspalt verringert und der Wirkungsgrad der Turbine gesteigert. Durch Einsatz des für die oxidationsbeständige Zwischenschicht verwendete Material auch als Bindermaterial in der verschleiss- und oxidationsbeständigen Schicht wird die Kompatibilität der beiden Schichten verbessert wird, was sich besonders gut auf ihre Eigenschaften auswirkt.

Von besonderem Vorteil ist, dass die oxidationsbeständige Zwischenschicht und die radial aussen liegende Abrasivschicht durch Laser Metal Forming generiert werden.

Die abrasive Schaufelspitze wird durch Laser Metal Forming (LMF) realisiert. Kern der Erfindung ist die Berücksichtigung spezieller Material- und Prozessanforderungen für den Einsatz auf einkristallinen Turbinenschaufeln. Dabei wird an der Grenzfläche zum Schaufelkörper zunächst eine oxidationsbeständige, einkristalline Pufferschicht realisiert, die epitaktisch auf dem einkristallinen Grundkörper der Turbinenschaufel erstarrt. Auf diese epitaktisch angebundene Pufferschicht wird dann die eigentliche Abrasivschicht aufgebracht. Wesentliches Merkmal der Abrasivschicht ist die komplette Einbettung der Abrasivteilchen in eine oxidationsbeständige Matrix. Ein weiteres Charakteristikum ist die homogene Verteilung der abrasiven Partikel in der Abrasivschicht.

Die beschriebene Ausführung einer abrasiven einkristallinen Turbinenschaufel ist vorteilhaft sowohl für die Neuteilfertigung, als auch für das Servicegeschäft (Retrofit) mit nur minimalen Anpassungen bestehender Fertigungsprozesse einsetzbar.

Weitere vorteilhafte Ausgestaltungen sind in den Unteransprüchen beschrieben.

So wird beispielsweise die epitäktische Zwischenschicht aus einer oxidationsbeständigen MCrAlY-Legierung (M steht dabei im Sinne der vorliegenden Schrift für Ni, Co oder die Kombination beider Elemente) von γ/β oder γ/γ' Typ realisiert, deren chemische Zusammensetzung so gewählt ist, dass bei der epitaktischen Erstarrung zunächst die γ-Phase ausgebildet wird und erst anschliessend die β-, bzw. γ'-Phase.

Es ist von Vorteil, wenn die chemische Zusammensetzung dieser Legierung so gewählt ist, dass diese im ternären Ni-Al-Cr- Phasendiagramm im γ-Phasenbereich und nahe zu der eutektischen Grenzlinie zwischen den γ- und β-, bzw. γ'-Phasenbereichen liegt. Das trifft auch für das Ni/Co-Cr-Al-Phasendiagramm zu, da Ni und Co vollständig mischbar sind, d.h. Co hat keinen Einfluss auf das Erstarrungsverhalten, nur auf die β-Phasenstabilitätstemperatur bzw. den β-Phasenanteil.

Weiterhin ist von Vorteil, wenn die epitaktisch auf den einkristallinen Grundkörper aufgebrachte Zwischenschicht aus einer oxidationsbeständigen Superlegierung vom γ/β oder γ/γ' Typ besteht mit folgender chemischer Zusammensetzung (Angaben in Gew.- %): 15-30 Cr, 5-10 Al, 0.3-1.2 Y, 0.1-1.2 Si, 0-2 andere, Rest Ni, Co oder aus einer oxidationsbeständigen Superlegierung vom γ/β Typ mit folgender chemischer Zusammensetzung (Angaben in Gew.- %): 35-39 Co, 18-24 Cr, 7-9 Al, 0.3-0.8 Y, 0.1-1 Si, 0-2 andere, Rest Ni, oder aus aus einer oxidationsbeständigen Superlegierung vom γ/γ' Typ mit folgender chemischer Zusammensetzung (Angaben in Gew.-%): 18-26 Cr, 5-8 Al, 0.3-1.2 Y, 0.1-1.2 Si, 0-2 andere, Rest Ni, Co. Diese Materialien sind besonders gut als Zwischenschichten geeignet. Von Vorteil ist, wenn das Material ein Erstarrungsintervall zwischen der Solidus- und Liquidustemperatur Δ T₀ von weniger als 50K und vorzugsweise weniger als 30K besitzt. Dadurch wird das Risiko der Rissbildung bei der Erstarrung verringert.

Die epitaktische Zwischenschicht besteht aus oxidationsbeständigem Material, das in seiner chemischen Zusammensetzung für den Einsatz mit der LMF-Methode optimiert ist. Die Zusammensetzung des Materials ist so gewählt, dass sich bei der Erstarrung aus der Schmelzphase zunächst die γ-Phase in ausbildet und diese epitaktisch auf dem Grundkörper der Turbinenschaufel erstarrt.

Ausserdem hat es sich als zweckmässig erwiesen, kubisches Bornitrid (cBN) als Abrasivmaterial in der verschleiss- und oxidationsbeständigen Schicht zu verwenden. Bei mehrlagigen verschleiss- und oxidationsbeständigen Schichten ist es von Vorteil, wenn der Anteil an Abrasivmaterial in radialer Richtung r nach aussen zunimmt, weil dann die äusserste Schicht den höchsten Anteil an Abrasivmaterial und damit die höchste Verschleissbeständigkeit aufweist.

### Kurze Beschreibung der Zeichnungen

In den Zeichnungen ist ein Ausführungsbeispiel der Erfindung dargestellt. Es zeigen:
- Fig. 1: eine Turbinenschaufel für den Rotor einer Gasturbine gemäss einem ersten Ausführungsbeispiel der Erfindung;
- Fig. 2: einen schematischen Schnitt entlang der Linie II-II in Fig. 1;
- Fig. 3: die Fertigungsabfolge bei der Herstellung einer abrasiven einkristallinen Turbinenschaufel gemäss einem zweiten Ausführungsbeispiel der Erfindung;
- Fig. 4: fotographische Aufnahmen von einer mit dem LMF-Verfahren erzeugten Kombination von Beschichtungen auf einer einkristallinen Turbinenschaufel und
- Fig. 5: die Beschichtungsvorrichtung und das Prinzip des E-LMF-Verfahrens.

### Wege zur Ausführung der Erfindung

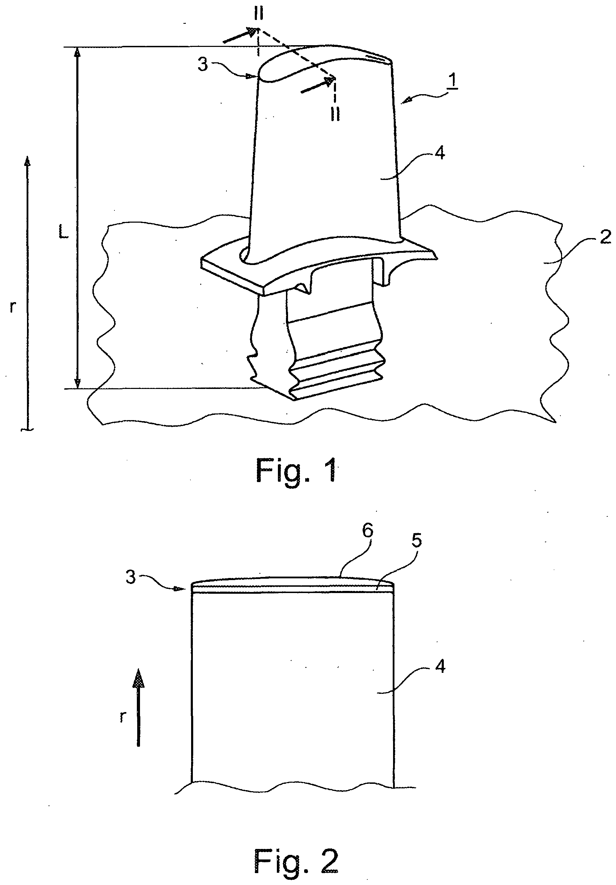

Nachfolgend wird die Erfindung anhand von Ausführungsbeispielen und der Fig. 1 bis 5 näher erläutert.

Fig. 1 zeigt in einer perspektivischen Darstellung eine Turbinenschaufe) 1 für einen (hier nur schematisch angedeuteten) Rotor 2 einer Gasturbine, während in Fig. 2 ein Schnitt entlang der Linie II-II in Fig. 1 vergrössert dargestellt ist. Die Turbinenschaufel 1 weist einen sich in radialer Richtung r (bezogen auf den Rotor) erstreckenden einkristallinen Grundkörper 4 auf, welcher erfindungsgemäss an der Schaufelspitze 3 eine durch LMF aufgebrachte epitaktische oxidationsbeständige Zwischenschicht 5 mit einer darauf aufgebrachten verschleiss- und oxidationsbeständigen Schicht 6 (siehe Fig._ 2) aufweist. Die Schicht 6 bedeckt hier die gesamte Zwischenschicht 5, aber es ist auch möglich, dass sie die Zwischenschicht 5 nur teilweise bedeckt. Das Grundmaterial des Schaufelgrundkörpers ist beispielsweise eine Einkristall-Nickel-Basis-Superlegierung. Die Oberfläche des Grundkörpers 4 ist in diesem ersten Ausführungsbeispiel vor Anwendung des LMF-Verfahrens unbeschichtet gewesen. Beide Schichten 5 und 6 können einlagig oder auch mehrlagig sein. Durch die Anzahl der mittels LMF-Verfahren aufgebrachten Schichten 5, 6 (bzw. durch die Anzahl der aufgebrachten Lagen) kann gut eine Variation der Länge L der Turbinenschaufel 1 realisiert werden.

Eine der Erfindung zugrunde liegende Idee besteht darin, die abrasive Schicht 6 auf die Zwischenschicht 5 (= Pufferschicht) aufzubauen, die epitaktisch auf dem einkristallinen Schaufelgrundkörper 4 erstarrt ist. Die epitaktische Zwischenschicht 5 besteht aus oxidationsbeständigem Material, das in seiner chemischen Zusammensetzung für den Einsatz mit der LMF-Methode optimiert ist. Die Zusammensetzung des Materials ist so gewählt, dass sich bei der Erstarrung aus der Schmelzphase zunächst die γ-Phase in ausbildet und diese epitaktisch auf dem Grundkörper 4 der Turbinenschaufel 1 erstarrt. Um das Risiko der Rissbildung bei der Erstarrung zu verringern, wird die Materialzusammensetzung so optimiert, dass das Erstarrungsintervall zwischen der Solidus- und Liquidustemperatur <50K und vorzugsweise <30K beträgt.

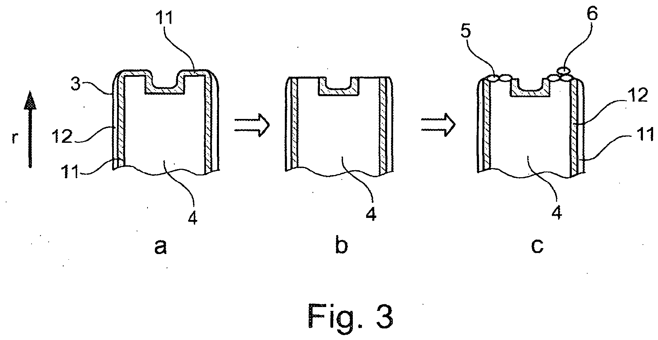

Die epitaktische Zwischenschicht 5 kann in einer ersten Variante (wie in Fig. 1 und 2 gezeigt) direkt auf die Schaufelspitze 3 einer unbeschichteten, einkristallinen Turbinenschaufel 1 aufgebracht werden. In einem alternativen Ansatz wird die epitaktische Zwischenschicht 5 so appliziert, dass sie zumindest teilweise mit anderen, bereits bestehenden Schutzschichten überlappt. Bei den bereits bestehenden Schutzschichten kann es sich dabei z.B. um sog. MCrAlY-Schichten 11 (M= Ni, Co, oder eine Kombination beider Elemente) handeln, die bei den meisten hochbelasteten Turbinenschaufeln die Oberflächen des Schaufelblattes gegen Oxidation und Korrosion schützen (siehe Fig. 3). In einer weiteren, dritten Variante (siehe Fig.3) befindet sich auf dem Schaufelblatt noch eine zusätzliche keramische Wärmedämmschicht 12 (TBC, Thermal Barrier Coating), die durch den anschliessenden Aufbau der abrasive Schaufelspitze nicht beschädigt wird.

Durch die Verwendung des speziell für den LMF-Prozess ausgelegten Materials für den Binder 7 und die Zwischenschicht 5, sowie durch eine kontrollierte Prozessführung, vorzugsweise mit on-line Regelung der Laserleistung, kann eine einkristalline, epitaktische Erstarrung der oxidationsbeständigen Zwischenschicht 5 auf dem einkristallinen Grundkörper 4 der Schaufel 1 erreicht werden. Das Risiko von Rissbildung bei der Erstarrung wird durch die optimierte Zusammensetzung des als Zwischenschicht 5 und als Binder 7 verwendeten Materials minimiert. Durch die Überlappung der oxidationsbeständigen Zwischenschicht 5 mit gegebenenfalls weiteren Schutzschichten 11, 12 auf dem Schaufelblatt wird ein effizienter Schutz der gegenüber dem Heissgas exponierten Flächen der Schaufelspitze 3 gewährleistet.

Falls zum Erreichen der gewünschten Schaufellänge L erforderlich, können auf die erste Zwischenschicht 5 weitere Lagen aus oxidationsbeständigem Material aufgebracht werden. Die eigentliche Abrasivschicht 6 wird entweder direkt auf die epitaktische Zwischenschicht 5, oder auf die oberste Lage aus oxidationsbeständigem Material appliziert. Hierzu werden Abrasivteilchen zusammen mit oxidationsbeständigem Bindermaterial (vorzugsweise aus dem für die Zwirchenschicht(en) verwendeten Material) vermischt und mit der LMF-Methode aufgebracht. Die Abrasivschicht 6 muss dabei die Zwischenschicht 5 nicht vollständig bedecken, sondern kann als Einzelspur, oder als Kombination von Segmenten aus Einzelspuren ausgebildet werden. Bei mehrlagigen Abrasivschichten 6 ist es vorteilhaft, wenn der Anteil an Abrasivmaterial 8 in radialer Richtung r nach aussen zunimmt, weil dann die äusserste Schicht 6 den höchsten Anteil an Abrasivmaterial 8 und damit die höchste Verschleissbeständigkeit aufweist

Durch die optimierte Wahl des Bindermaterials können auch für diese Schicht folgende Vorteile gleichzeitig ausgenützt werden:
- Geringe Anfälligkeit auf Rissbildung
- hohe Oxidationsresistenz
- gute Benetzung und Umhüllung der Abrasivteilchen

Fertigungstechnisch ist die Realisierung der abrasiven, einkristallinen Schaufelspitze durch das E-LMF-Verfahren nach vorangehender konventioneller Beschichtung des Schaufelblattes besonders interessant: Bei dieser Prozessabfolge müssen bestehende Fertigungsprozesse nur minimal verändert werden und es kann auf die Maskierung der Abrasivschicht während der Applikation der MCrAlY-Schutzschichten auf dem Schaufelblatt verzichtet werden. Somit ist die Komponente (Turbinenschaufel 1) unmittelbar nach dem Applizieren der abrasiven Schaufelspitze ohne weitere nachfolgende Schritte einsetzbar. Es kann vorteilhaft auf eine weitere Wärmebehandlung verzichtet werden.

Eine mögliche Fertigungsabfolge bei der Herstellung einer erfindungsgemässen abrasiven einkristallinen Turbinenschaufel 1 ist in Fig. 3 dargestellt. Auf der Oberfläche eines Schaufelkörpers 4, welches aus einem einkristallinen Material, beispielsweise einer einkristallinen Ni-Basis-Superlegierung besteht, ist eine MCrAlY-Haftschicht 11 aufgebracht, auf die wiederum eine keramische Wärmedämmschicht (TBC) 12 aufgebracht ist (siehe Fig. 3a). An der radial aussen gelegenen Schaufelspitze 3, welche in diesem Ausführungsbeispiel als Krone ausgebildet ist, wird die Beschichtung mechanisch/und oder chemisch abgetragen, z.B. abgeschliffen, abgefräst oder abgeätzt (siehe Fig. 3b), so dass an dieser Stelle die Oberfläche des einkristallinen Grundkörpers 4 frei von Schutzschichten, also unbedeckt ist. Anschliessend wird erfindungsgemäss mittels E-LMF eine epitaktisch erstarrte Zwischenschicht 5 und darauf eine abrasive Schicht 6 aufgebracht (siehe Fig. 3c).

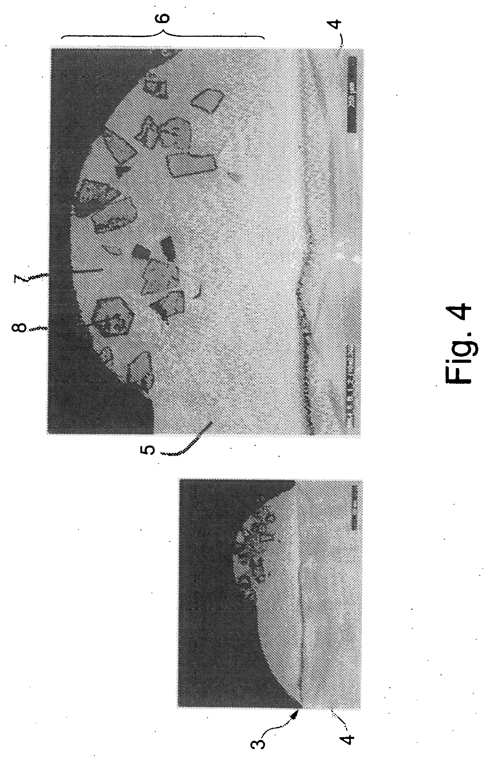

Fig. 4 zeigt in fotographischen Aufnahmen ein Realisierungsbeispiel einer solchen abrasiven einkristallinen Schaufelspitze 3, die mit der LMF-Methode erzeugt wurde. Die Schaufelspitze 3 ist hier als Krone ausgebildet. Als Strahlquelle wurde ein fasergekoppelter Hochleistungsdiodenlaser mit 1000W Ausgangsleistung verwendet. Auf dem einkristallinen Grundkörper 4 (Ni-Basis-Superlegierung MK4) ist an der radial aussen liegenden Oberfläche zunächst die epitaktisch und einkristallin erstarrte Zwischenschicht 5 (Pufferschicht) aus der kommerziell unter der Bezeichnung Amdry 995 bekannten Legierung angeordnet, deren optimale Mikrostruktur sich auch am Interface zu der darüber liegenden Abrasivschicht 6 fortsetzt, welches in diesem Ausführungsbeispiel aus Amdry 995 als Bindermaterial 7 und darin eingebetteten cBN-Teilchen als Abrasivmaterial 8 besteht. Naturgemäss ist oberhalb der ersten Abrasivteilchen 8 keine Fortsetzung der einkristallinen Mikrostruktur mehr möglich.

Als Material für die epitaktische Zwischenschicht 5 bzw. als Bindermaterial 7 sind folgende Legierungen geeignet:
- oxidationsbeständige MCrAlY-Legierungen (M = Ni, Co oder Kombinationen aus beiden Elementen) vom γ/β oder γ/γ' Typ, deren chemische Zusammensetzung so gewählt ist, dass bei der epitaktischen Erstarrung zunächst die γ-Phase ausgebildet wird und erst anschliessend die β-, bzw. γ'-Phase ;
- oxidationsbeständige MCrAlY-Legierungen vom γ/β oder γ/γ' Typ, deren chemische Zusammensetzung so gewählt ist, dass diese im ternären Ni-Al-Cr- Phasendiagramm bzw. Ni/Co-Al-Phasendiagramm im γ-Phasenbereich und nahe zu der eutektischen Grenzlinie zwischen den γ- und β-, bzw. γ'-Phasenbereichen liegt;
- oxidationsbeständige MCrAlY-Legierungen vom γ/β oder γ/γ' Typ mit folgender chemischer Zusammensetzung (Angaben in Gew.- %): 15-30 Cr, 5-10 Al, 0.3-1.2 Y, 0.1-1.2 Si, 0-2 andere, Rest Ni, Co;
- oxidationsbeständige MCrAlY-Legierungen vom γ/β Typ mit folgender chemischer Zusammensetzung (Angaben in Gew.- %): 35-39 Co, 18-24 Cr, 7-9 Al, 0.3-0.8 Y, 0.1-1 Si, 0-2 andere, Rest Ni;
- oxidationsbeständige MCrAlY-Legierungen vom γ/γ' Typ mit folgender chemischer Zusammensetzung (Angaben in Gew.- %): 18-26 Cr, 5-8 Al, 0.3-1.2 Y, 0.1-1.2 Si, 0-2 andere, Rest Ni, Co.

Diese Materialien sind besonders gut als Zwischenschichten 5, aber auch als Bindermaterial 7 in den abrasiven Schichten 6 geeignet. Von Vorteil ist, wenn das Material ein Erstarrungsintervall zwischen der Solidus- und Liquidustemperatur ΔT₀ von weniger als 50K und vorzugsweise weniger als 30K besitzt. Dadurch wird das Risiko bei der Rissbildung bei der Erstarrung verringert.

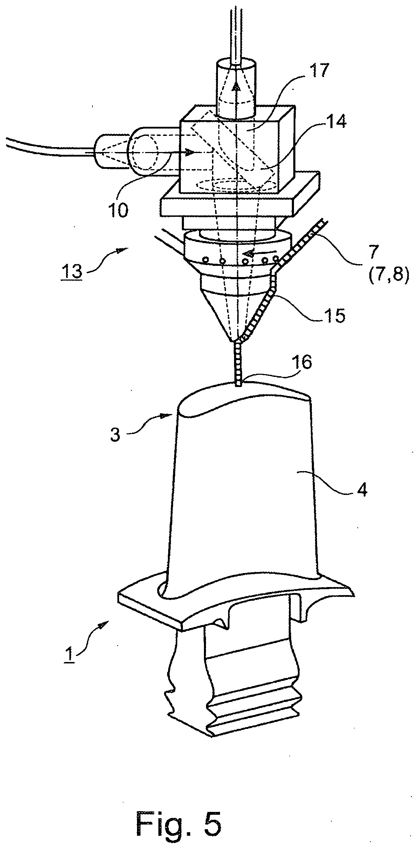

Fig. 5 zeigt eine Beschichtungsvorrichtung 13 zur Ausführung des erfindungsgemässen Verfahrens und den (epitaktischen) LMF Prozess mit koaxialer Eindüsung der Pulverteilchen um einen fokussierten Laserstrahl 10 hoher Intensität. Die Vorrichtung 13 ist in EP 1 476 272 B1 im Detail beschrieben, der Inhalt dieses Dokuments ist Bestandteil der vorliegenden Anmeldung. Eine mit Hilfe eines nicht in Fig. 5 dargestellten Roboters erfolgte Bewegung der Pulverdüse (oder des Werkstücks, hier Turbinenschaufel 1) erlaubt eine volle 6-Achsen-Flexibilität des Prozesses. Ein dichroitischer Spiegel 14 lenkt das hochintensive Laserlicht 10 auf die Komponente 1 und fokussiert es auf einen kleinen Zielpunkt. Der Spiegel 14 ist transparent für das Prozesslicht, welches gekoppelt ist an ein nicht dargestelltes optisches Pyrometer, das eine on-line Kontrolle der Temperatur des Schmelzbads 16 ermöglicht.

Beim Laserauftragsschweissen der Schaufelspitze 3 werden das Material 7 für die Zwischenschicht 5 (oder Abrasivmaterial 8 und oxidationsbeständiges Bindermaterial 7 für die Schicht 6) in einer Pulverdüse gemischt, mittels eines Trägergases 15 transportiert und anschliessend konzentrisch um den Laserstrahl 10 als fokussierter Pulverstrahl in das vom Laserstrahl 10 erzeugte Schmelzbad 16 an der Schaufelspitze 3 eingedüst. Zusätzlich wird während des Laserauftragsschweissens on-line die Temperatur oder Temperaturverteilung im Schmelzbad erfasst (optisches Temperatursignal 17) und diese Information wird mit Hilfe eines nicht in Fig. 5 dargestellten Regelsystems verwendet, um die Laserleistung während des Laserauftragschweissens zu kontrollieren und/ oder die Relativbewegung zwischen dem Laserstrahl 10 und der Turbinenschaufel 1 kontrolliert zu verändern.

Im beschriebenen Beispiel ermöglicht das integriertes Pyrometer die Bestimmung der Schmelzbadtemperatur während des Laserprozesses. Durch Rücckopplung des Temperatursignals 17 an den nicht dargestellten Lasercontroller kann Ober einen Echtzeit-Regelprozess die Laserleistung automatisch so angepasst werden, dass die zur epitaktischen Erstarrung erforderlichen Kriterien erfüllt werden: Dazu muss der Quotient Gⁿ/V₆ oberhalb eines materialabhängigen Grenzwertes liegen, der zur gerichteten, einkristallinen Erstarrung erforderlich ist. Hierbei bezeichnet G den lokalen Temperaturgradienten, Vₛ die Geschwindigkeit der Erstarrungsfront und n einen weiteren Materialparameter.

Durch die Erfindung wird ein kostengünstiges und einfach umsetzbares. Verfahren zur Herstellung von abrasiven Schutzschichten für einkristalline Turbinenschaufeln offengelegt. Durch die komplette Einbettung der Abrasivteilchen in eine oxidationsbeständige Bindermatrix wird die nutzbare Lebensdauer der Abrasivschicht bei hohen Einsatztemperaturen verlängert. So können die Vorteile von Abrasivbeschichtungen mindestens über die Dauer des Einlaufvorgangs gewährleistet werden.

Durch die speziellen Materialeigenschaften des Binders wird einerseits eine gute Oxidationsbeständigkeit gewährleistet. Andererseits ist das Material hinsichtlich seiner Erstarrungseigenschaften für den Einsatz mit epitaktischen Laser Metal Forming (E-LMF) optimiert: So wird die vorteilhafte epitaktische Anbindung an das Grundmaterial bei gleichzeitig minimalem Risiko von Defektausbildung erreichbar. Da einkristalline Komponenten, wie z.B. einkristalline Turbinenschaufeln, den grössten thermo-mechanischen Belastungen ausgesetzt sind, ist die Erhaltung der mechanischen Integrität (keine Defekte, bzw. Risse) eine Schlüsselvoraussetzung für den Einsatz in einer Turbine.

Die Abrasivbeschichtungen von einkristallinen Turbinenschaufeln haben ein sehr grosses kommerzielles Potential in leistungsfähigen Turbinen modernster Generation. Einkristalline Komponenten werden hier in der ersten Turbinenstufe (HPT=Hochdruckturbine und/oder LPT=Niederdruckturbine) eingesetzt. Für diese Komponenten existiert zur Zeit noch keine gute Lösung zur Optimierung von Heissgas-Leckageverlusten. Mit der vorliegenden Erfindung wird es möglich, die Leckage zwischen dem Hitzeschild und den Spitzen der Turbinenschaufeln zu verringern. Während der nutzbaren Lebensdauer der Abrasivschicht können dabei im Rahmen einer geeignet ausgelegten Einlaufprozedur Ovalisierung des Gehäuses, bzw. Exzentrizität zwischen Rotor und Gehäuse durch Einschleifen der Turbinenschaufeln korrigiert werden.

Auch nach dem Verlust der Abrasivschicht bleibt der Grundkörper der Schaufel durch die gute Oxidationsbeständigkeit des als Binder und Pufferschicht verwendeten Schweissfüllers während der gesamten nominalen Lebensdauer geschützt.

Durch die erhöhte Verschleissbeständigkeit der abrasiven Turbinenschaufel gegenüber Reibkontakten können relativ dichte keramische Beschichtungen an den Hitzeschildern appliziert werden. Gutes Einreibverhalten während einer Einlaufprozedur kann so mit der erforderlichen Langzeit-Erosionsbeständigkeit der keramischen Beschichtungen auf den Hitzeschildern kombiniert werden.

Ein interessantes kommerzielles Potential besteht auch im Retrofit, bzw. Rekonditionieren bestehender Schaufeln. Diese können mit der erfindungsgemässen Methode modifiziert werden, um beim Neueinbau geringere Leckageverluste und damit einen verbesserten Wirkungsgrad der Turbine zu erreichen. Für diese Option muss dabei vorher nicht eine eventuell bereits bestehende Schutzschicht auf dem Schaufelblatt entfernt werden. Damit ergibt sich eine interessante Option für das Rekonditionieren von einkristallinen Gasturbinenschaufeln

Die Erfindung ist für den Einsatz mit allen einkristallinen Turbinenschaufeln 1 vorgesehen. Zu beachten ist die von den jeweiligen Betriebsbedingungen (Temperatur, Brennstoff) abhängige begrenzte Lebensdauer der Abrasivbeschichtung 6. Durch eine gute Verteilung und komplette Einbettung der Abrasivteilchen 8 in die oxidationsbeständige Bindermatrix 7 wird eine Lebensdaueroptimierung erreicht. Dennoch ist das Hauptziel der Erfindung, die Turbinenschaufelspitze 3 vor allem während der Einlaufphase (mehrere Dutzend bis Hundert Betriebsstunden) zu schützen. Um bestmöglichen Nutzen aus den speziellen Eigenschaften der abrasiven Schutzschicht 6 zu ziehen, sollte eine auf die abrasiven Turbinenschaufeln 1 abgestimmte Einlaufprozedur verwendet werden.

Selbstverständlich ist die Erfindung nicht auf die beschriebenen Ausführungsbeispiele beschränkt.

### Bezugszeichenliste

- 1: Turbinenschaufel
- 2: Rotor
- 3: Schaufelspitze
- 4: einkristalliner Grundkörper
- 5: epitaktische oxidationsbeständige Zwischenschicht
- 6: verschleiss- und oxidationsbeständige Schicht
- 7: Bindermaterial
- 8: Abrasivmaterlal
- 10: Laserstrahl
- 11: Metallische Schutzschicht (MCrAlY-Schicht)
- 12: Keramische Wärmedämmschicht (TBC)
- 13: Beschichtungsvorrichtung
- 14: dichroitischer Spiegel
- 15: Trägergas
- 16: Schmelzbad
- 17: optisches Temperatursignal
- r: radiale Richtung
- L: Länge der Turbinenschaufel

## Patentansprüche

1. Verfahren zur Herstellung einer Turbinenschaufel (1) für den Rotor (2) einer Turbine, mit einem eine Schaufelspitze (3) aufweisenden sich in radialer Richtung (r) erstreckenden einkristallinen Grundkörper (4) und einer radial aussen gelegenene Schaufelspitze (3), **dadurch gekennzeichnet, dass** an der Schaufelspitze (3) mindestens eine oxidationsbeständige MCrAlY-Zwischenschicht (5) mittels Laserauftragsschweissen epitaktisch auf die Oberfläche des Grundkörper (4) aufgebracht wird und auf dieser epitaktischen Zwischenschicht (5) mittels Laserauftragsschweissen zumindest bereichsweise eine mindestens einlagige, verschleiss- und oxidationsbeständige Schicht (6) aus oxidationsbeständigem Bindermaterial (7) und darin eingebetteten Abrasivteilchen (8) aufgebracht wird, wobei das für die oxidationsbeständige Zwischenschicht (5) verwendete Material auch als Bindermaterial (7) in der verschleiss- und oxidationsbeständigen Schicht (6) verwendet wird, wobei die MCrAlY-Legierung vom γ/β oder γ/γ' Typ besteht.

2. Verfahren nach Anspruch 1, **dadurch gekennzeichnet, dass** während des Aufbaus der Zwischenschicht (5) und der verschleiss- und oxidationsbeständigen Schicht (6) mit dem Laserauftragsschweissverfahren on-line die Temperatur oder Temperaturverteilung im Schmelzbad (16) erfasst wird, dass diese Information mit Hilfe eines Regelsystems verwendet wird, um die Laserleistung während des Laserauftragsschweissverfahrens und/oder die Relativbewegung zwischen Laserstrahl (10) und Turbinenschaufel (1) so zu kontrollieren, dass der Quotient Gⁿ/Vₛ oberhalb des materialabhängigen Grenzwertes liegt, der zur gerichteten, einkristallinen Erstarrung erforderlich ist, wobei mit G der lokale Temperaturgradient, Vₛ die Geschwindigkeit der Erstarrungsfront und n ein weiterer Materialparameter bezeichnet sind.

3. Verfahren nach Anspruch 1, **dadurch gekennzeichnet, dass** beim Schritt des Laserauftragsschweissens zur Erzeugung der verschleiss- und abrasiven Schicht (6) Abrasivteilchen (8) und oxidationsbeständiges Bindermaterial (7) in einer Pulverdüse gemischt und anschliessend konzentrisch um den Laserstrahl (10) als fokussierter Pulverstrahl in das Schmelzbad (16) eingedüst werden.

4. Verfahren nach einem der Ansprüche 1 bis 3, wobei in einem vorausgegangenen Herstellungsschritt der Grundkörper (4) der Turbinenschaufel (1) auf seiner Oberfläche entweder in bestimmten Zonen oder vollständig mit einer oxidationsbeständigen metallischen Schutzschicht (11), insbesondere einer MCrAIY-Schicht, beschichtet und wahlweise auf diese Schutzschicht (11) eine oxidationsbeständige keramische Wärmedämmschicht (12) aufgebracht wird, **dadurch gekennzeichnet, dass** die mindestens eine metallische und keramische Schutzschicht (11, 12) an der radial aussen gelegenen Schaufelspitze (3) durch kontrollierte mechanische Bearbeitung, insbesondere Abschleifen, CNC Fräsen, und/oder chemisches Entschichten, entfernt wird, und die nachfolgend durch das Laserauftragsschweissen aufgebaute epitaktisch erstarrte oxidationsbeständige Zwischenschicht (5) so aufgebracht wird, dass sie nur mit der sich in radialer Richtung erstreckenden MCrAlY-Schicht (11), nicht aber mit der darauf vorhandenen zusätzlichen keramischen Wärmedämmschicht (12), vollständig oder teilweise überlappt.

5. Verfahren nach Anspruch 1, **dadurch gekennzeichnet, dass** als Zwischenschicht (5) eine oxidationsbeständige MCrAlY-Legierung vom γ/β oder γ/γ' Typ aufgebracht wird, deren chemische Zusammensetzung so gewählt ist, dass bei der epitaktischen Erstarrung zunächst die γ-Phase ausgebildet wird und erst anschliessend die β- bzw. γ'-Phase.

6. Verfahren nach Anspruch 1, **dadurch gekennzeichnet, dass** als Zwischenschicht (5) eine oxidationsbeständigen MCrAIY-Legierung aufgebracht wird, welche ein Erstarrungsintervall zwischen der Solidus- und Liquidustemperatur ΔT₀ von weniger als 50K, vorzugsweise weniger als 30K aufweist.

7. Verfahren nach Anspruch 1, **dadurch gekennzeichnet, dass** als Zwischenschicht (5) eine oxidationsbeständigen MCrAIY-Legierung vom γ/β oder γ/γ' Typ aufgebracht wird, deren chemische Zusammensetzung so gewählt ist, dass diese im ternären Ni-Al-Cr- Phasendiagramm bzw. Ni/Co-Al-Cr-Phasendiagramm im γ-Phasenbereich und nahe zu der eutektischen Grenzlinie zwischen den γ- und β-, bzw. γ'-Phasenbereichen liegt.

8. Verfahren nach Anspruch 1, **dadurch gekennzeichnet, dass** als Zwischenschicht (5) einer oxidationsbeständige MCrAIY-Legierung vom γ/β oder γ/γ Typ aufgebracht wird mit folgender chemischer Zusammensetzung (Angaben in Gew.- %): 15-30 Cr, 5-10 AI, 0.3-1.2 Y, 0.1-1.2 Si, 0-2 andere, Rest Ni, Co.

9. Verfahren nach Anspruch 1, **dadurch gekennzeichnet, dass** als Zwischenschicht (5) eine oxidationsbeständigen MCrAIY-Legierung vom γ/β Typ aufgebracht wird mit folgender chemischer Zusammensetzung (Angaben in Gew.- %): 35-39 Co, 18-24 Cr, 7-9 AI, 0.3-0.8 Y, 0.1-1 Si, 0-2 andere, Rest Ni.

10. Verfahren nach Anspruch 1, **dadurch gekennzeichnet, dass** das als Zwischenschicht (5) eine oxidationsbeständige MCrAIY-Legierung vom γ/γ' Typ aufgebracht wird mit folgender chemischer Zusammensetzung (Angaben in Gew.- %): 18-26 Cr, 5-8 Al, 0.3-1.2 Y, 0.1-1.2 Si, 0-2 andere, Rest Ni, Co.

11. Verfahren nach Anspruch 1, **dadurch gekennzeichnet, dass** als Abrasivmaterial (8) in der verschleiss- und oxidationsbeständigen Schicht (6) kubisches Bornitrid (cBN) verwendet wird.

12. Verfahren nach Anspruch 1, **dadurch gekennzeichnet, dass** beim Aufbringen einer mehrlagigen verschleiss- und oxidationsbeständigen Schicht (6) der Anteil an Abrasivmaterial (8) von Lage zu Lage in radialer Richtung (r) nach aussen erhöht wird.

13. Turbinenschaufel (1) für den Rotor (2) einer Turbine, mit einem eine Schaufelspitze (3) aufweisenden sich in radialer Richtung (r) erstreckenden einkristallinen Grundkörper (4) und einer radial aussen gelegenene Schaufelspitze (3), **dadurch gekennzeichnet, dass** diese Turbinenschaufel (1) nach einem Verfahren gemäss einem der Ansprüche 1 bis 12 hergestellt ist und mindestens eine an der Schaufelspitze (3) angeordneten oxidationsbeständige MCrAIY-Zwischenschicht (5), welche epitaktisch mit dem Grundkörper (4) verbunden ist, aufweist, sowie eine darauf angeordnete mindestens einlagige verschleiss- und oxidationsbeständige Schicht (6).

14. Turbinenschaufel (1) nach Anspruch 13 mit einer Länge (L), **dadurch gekennzeichnet, dass** die Länge (L) durch die Anzahl der mittels Laserauftragsschweissen aufgebauten oxidationsbeständigen epitaktischen Zwischenschichten (5) und/oder verschleiss- und oxidationsbeständigen Schichten (6) variierbar ist.

## Claims

1. Method for production of a turbine blade (1) for the rotor (2) of a turbine, with a monocrystalline base body (4) extending in a radial direction (r) and comprising a blade tip (3), and with a radially outwardly located blade tip (3), **characterised in that** at the blade tip (3), at least one oxidation-resistant MCrAlY intermediate layer (5) is applied epitaxially on the surface of the base body (4) by means of laser application welding, and on this epitaxial intermediate layer (5), at least in regions, at least one monolayer wear- and oxidation-resistant layer (6) is applied by means of a laser application welding and consists of oxidation-resistant binder material (7) with abrasive particles (8) embedded therein, wherein the material used for the oxidation-resistant intermediate layer (5) is also used as a binder material (7) in the wear- and oxidation-resistant layer (6), wherein the MCrAlY layer consists of the γ/β or γ/γ' type.

2. Method according to claim 1, **characterised in that** during construction of the intermediate layer (5) and the wear- and oxidation-resistant layer (6) with the laser application welding process, the temperature or temperature distribution in the melt bath (16) is detected on-line, that this information is used by a control system to control the laser power during the laser application welding process and/or the relative movement between the laser beam (10) and the turbine blade (1), such that the quotient Gⁿ/Vₛ lies above the material-dependent limit value necessary for the directed monocrystalline solidification, wherein G is the local temperature gradient, Vₛ the speed of the solidification front, and n a further material parameter.

3. Method according to claim 1, **characterised in that** in the step of laser application welding to generate the wear and abrasive layer (6), abrasive particles and oxidation-resistant binder material (7) are mixed into a powder nozzle and then injected concentrically around the laser beam (10) as a focused powder jet into the melt bath (16).

4. Method according to any of claims 1 to 3, wherein in a preceding production step, the surface of the base body (4) of the turbine blade (1) is coated either in specific zones or completely with an oxidation-resistant metallic protective layer (11), in particular a MCrAlY layer, and optionally an oxidation-resistant ceramic heat-insulating layer (12) is applied on this protective layer (11), **characterised in that** the at least one metallic and ceramic protective layer (11, 12) on the radially outward located blade tip (3) is removed by controlled mechanical machining, in particular abrasion, CNC milling and/or chemical coating removal, and the epitaxially solidified oxidation-resistant intermediate layer (5) constructed by the laser application welding is then applied so that it overlaps partly or completely only with the MCrAlY layer (11) extending in the radial direction but not with the additional ceramic heat-insulating layer (12) present thereon.

5. Method according to claim 1, **characterised in that** as an intermediate layer (5), an oxidation-resistant MCrAlY alloy of the γ/β or γ/γ' type is applied, the chemical composition of which is selected such that on epitaxial solidification, firstly the γ phase is formed and only then the β or γ' phase.

6. Method according to claim 1, **characterised in that** as an intermediate layer (5), an oxidation-resistant MCrAlY alloy is applied which has a solidification interval between the solid and liquid temperature ΔT₀ of less than 50 K, preferably less than 30 K.

7. Method according to claim 1, **characterised in that** as an intermediate layer (5), an oxidation-resistant MCrAlY alloy of the γ/β or γ/γ' type is applied, the chemical composition of which is selected such that this lies in the ternary Ni-Al-Cr phase diagram or Ni/Co-Al-Cr phase diagram in the γ phase region and close to the eutectic border line between the γ and β or γ' phase regions.

8. Method according to claim 1, **characterised in that** as an intermediate layer (5), an oxidation-resistant MCrAlY alloy of the γ/β or γ/γ' type is applied with the following chemical composition (data in w.%): 15-30 Cr, 5-10 Al, 0.3-1.2 Y, 0.1-1.2 Si, 0-2 other, remainder Ni, Co.

9. Method according to claim 1, **characterised in that** as an intermediate layer (5), an oxidation-resistant MCrAlY alloy of the γ/β type is applied with the following chemical composition (data in w.%): 35-39 Co, 18-24 Cr, 7-9 Al, 0.3-0.8 Y, 0.1-1 Si, 0-2 other, remainder Ni.

10. Method according to claim 1, **characterised in that** as an intermediate layer (5), an oxidation-resistant MCrAlY alloy of the γ/γ' type is applied with the following chemical composition (data in w.%): 18-26 Cr, 5-8 Al, 0.3-1.2 Y, 0.1-1.2 Si, 0-2 other, remainder Ni, Co.

11. Method according to claim 1, **characterised in that** as an abrasive material (8) in the wear- and oxidation-resistant layer (6), cuboid boron nitride (cBN) is used.

12. Method according to claim 1, **characterised in that** on application of a multilayer wear- and oxidation-resistant layer (6), the proportion of abrasive material (8) is increased outwardly in the radial direction (r) from layer to layer.

13. Turbine blade (1) for the rotor (2) of a turbine, with a monocrystalline base body (4) extending in radial direction (r) and comprising a blade tip (3), and with a radially outwardly located blade tip (3), **characterised in that** said turbine blade (1) is produced in a method according to any of claims 1 to 12, and at least one oxidation-resistant MCrAlY intermediate layer (5) is applied at the blade tip and bonded epitaxially to the base body (4), and at least one monolayer wear- and oxidation-resistant layer (6) is arranged thereon.

14. Turbine blade (1) according to claim 13 with a length (L), **characterised in that** the length (L) can be varied by the number of oxidation-resistant epitaxial intermediate layers (5) constructed by means of laser application welding, and/or by the number of wear- and oxidation-resistant layers (6).

## Revendications

1. Procédé de fabrication d'une pale de turbine (1) pour le rotor (2) d'une turbine, avec un corps de base monocristallin (4) comprenant une pointe de pale (3) et s'étendant dans la direction radiale (r) et une pointe de pale (3) disposée radialement à l'extérieur, **caractérisé en ce que,** au niveau de la pointe de pale (3), au moins une couche intermédiaire MCrAIY (5) résistante à l'oxydation est appliquée de manière épitaxiale au moyen d'une soudure laser par apport sur la surface du corps de base (4) et sur cette couche intermédiaire épitaxiale (5), au moyen d'une soudure laser par apport, est appliquée, au moins sur certaines zones, une couche (6) au moins monocouche, résistante à l'usure et à l'oxydation, constituée d'un matériau liant (7) résistant à l'oxydation et de particules abrasives (8) intégrées à l'intérieur, le matériau utilisé pour la couche intermédiaire (5) résistante à l'oxydation étant également utilisé en tant que matériau liant (7) dans la couche (6) résistante à l'usure et à l'oxydation, où est appliqué un alliage MCrAIY résistant à l'oxydation de type ou γ/γ'.

2. Procédé selon la revendication 1, **caractérisé en ce que,** pendant l'application de la couche intermédiaire (5) et la couche (6) résistante à l'usure et à l'oxydation avec la soudure laser par apport, la température ou la distribution de la température est mesurée en ligne dans le bain de fusion (16), **en ce que** cette information est utilisée à l'aide d'un système de régulation afin de contrôler la puissance laser pendant le procédé de soudure laser par apport et/ou le mouvement relatif entre le rayon laser (10) et la pale de turbine (1) de façon à ce que le quotient Gⁿ/Vₛ se trouve au-dessus de la valeur limite dépendant du matériau, qui est nécessaire pour la solidification monocristalline, G désignant le gradient de température local, Vs désignant la vitesse du front de solidification et n désignant un autre paramètre du matériau.

3. Procédé selon la revendication 1, **caractérisé en ce que,** lors de l'étape de soudure laser par apport, pour la génération de la couche (6) résistante à l'usure et à l'oxydation, des particules abrasives (8) et un matériau liant (7) sont mélangés dans une buse de pulvérisation puis introduits de manière concentrique autour du rayon laser (10) sous la forme d'un jet de pulvérisation focalisé dans le bain de fusion (16).

4. Procédé selon l'une des revendications 1 à 3, le corps de base (4) de la pale de turbine (1) étant revêtu, sur sa surface, soit dans certaines zones ou entièrement, avec une couche de protection métallique (11) résistante à l'oxydation, plus particulièrement une couche MCrAlY, et, sur cette couche de protection (11), une couche d'isolation thermique (12) en céramique résistante à l'oxydation étant appliquée, **caractérisé en ce qu' au** moins une couche de protection métallique et céramique (11, 12) est éliminée, au niveau de la pointe de pale (3) disposée à l'extérieur par un usinage mécanique contrôlée, plus particulièrement un meulage, un fraisage CNC et/ou un décapage chimique et la couche intermédiaire (5) résistante à l'oxydation et solidifiée de manière éptaxiale formée ensuite par la soudure laser par apport étant appliquée de façon à ce qu'elle se superpose entièrement ou partiellement uniquement avec la couche MCrAIY (11), mais pas avec la couche d'isolation thermique céramique (12) supplémentaire.

5. Procédé selon la revendication 1, **caractérisé en ce que,** en tant que couche intermédiaire (5), est appliqué un alliage MCrAIY résistant à l'oxydation de type ou γ/γ', dont la composition chimique est choisie de façon à ce que, lors de la solidification épitaxiale, la phase γ soit d'abord formée, puis la phase β ou la phase γ'.

6. Procédé selon la revendication 1, **caractérisé en ce que,** en tant que couche intermédiaire (5), est appliqué un alliage MCrAIY résistant à l'oxydation, qui présente un intervalle de solidification entre la température de solidus et de liquidus ΔT₀ inférieur à 50 K, de préférence inférieur à 30 K.

7. Procédé selon la revendication 1, **caractérisé en ce que,** en tant que couche intermédiaire (5), est appliqué un alliage MCrAIY résistant à l'oxydation de type ou γ/γ', dont la composition chimique est choisie de façon à ce que celle-ci se trouve, dans le diagramme de phase Ni-AI-Cr ou le diagramme de phase Ni/Co-Al-Cr dans le domaine de phase γ et proche de la ligne de limite eutectique entre les domaines de phases γ et β ou γ'.

8. Procédé selon la revendication 1, **caractérisé en ce que,** en tant que couche intermédiaire (5), est appliqué un alliage MCrAIY résistant à l'oxydation de type ou γ/γ', avec la composition chimique suivante (indications en % en poids) : 15-30 Cr, 5-10 Al, 0,3-1,2 Y, 0,1-1,2 Si, 0-2 autres, reste Ni, Co.

9. Procédé selon la revendication 1, **caractérisé en ce que,** en tant que couche intermédiaire (5), est appliqué un alliage MCrAIY résistant à l'oxydation de type avec la composition chimique suivante (indications en % en poids) : 35-39 Co, 18-24 Cr, 7-9 Al, 0,3-0,8 Y, 0,1-1 Si, 0-2 autres, reste Ni.

10. Procédé selon la revendication 1, **caractérisé en ce que,** en tant que couche intermédiaire (5), est appliqué un alliage MCrAIY résistant à l'oxydation de type γ/γ' avec la composition chimique suivante (indications en % en poids) : 18-26 Cr, 5-8 Al, 0,3-1,2 Y, 0,1 - 1,2 Si, 0-2 autres, reste Ni, Co.

11. Procédé selon la revendication 1, **caractérisé en ce que,** en tant que matériau abrasif (8) dans la couche (6) résistante à l'usure et à l'oxydation, du nitrure de bore cubique (cBN) est utilisé.

12. Procédé selon la revendication 1, **caractérisé en ce que,** lors de l'application d'une couche (6) multicouche résistante à l'usure et à l'oxydation, la part de matériau abrasif (8) est augmentée de couche en couche dans la direction radiale (r) vers l'extérieur.

13. Pale de turbine (1) pour le rotor (2) d'une turbine, avec un corps de base (3) monocristallin comprenant une pointe de pale (3) et s'étendant dans la direction radiale (r) (4) et une pointe de pale (3) disposée radialement à l'extérieur, **caractérisée en ce que** cette pale de turbine (1) est fabriquée selon un procédé selon l'une des revendications 1 à 12 et comprend au moins une couche intermédiaire MCrAIY (5) résistante à l'oxydation disposée sur la pointe de pale (3), qui est reliée de manière éptaxiale avec le corps de base (4), ainsi qu'une couche (6) au moins monocouche, résistante à l'usure et à l'oxydation disposée par-dessus.

14. Pale de turbine (1) selon la revendication 13, avec une longueur (L), **caractérisée en ce que** la longueur (L) peut être modifiée par le nombre de couches intermédiaires épitaxiales (5) résistantes à l'oxydation appliquées au moyen d'une soudure laser par apport et/ou des couches (6) résistantes à l'usure et à l'oxydation.
